# FASCICULE DE BREVET EUROPEEN

(11) **EP 2 685 268 B1**
(45) Date de publication et mention de la délivrance du brevet: **28.01.2015**
(21) Numéro de dépôt: 12290233.1
(22) Date de dépôt: 13.07.2012
(51) Int. Cl.: G01R 31/12, H01H 9/50, H02B 13/065, H02H 1/00

(54) **Capteur de mesure ultra-haute-fréquence de décharge partielle**
UHF-Sensor zur Teilentladungsmessung
Sensor for ultra high-frequency partial discharge measurement

(43) Date de publication de la demande: 15.01.2014
(73) Titulaire: Siemens Aktiengesellschaft, 80333 München (DE)
(72) Inventeur: Charot, Gerard, 38190 Villard Bonnot (FR); Jacquemier, Lucien, 38210 Vourey (CH)
(74) Mandataire: Maier, Daniel Oliver

(56) Documents cités:
- WO-A1-2004/083878
- US-A1- 2010 084 187
- JUDD M D ED - INSTITUTE OF ELECTRICAL AND ELECTRONICS ENGINEERS: "DIELECTRIC WINDOWS IMPROVE SENSITIVITY OF PARTIAL DISCHARGE DETECTION AT UHF", CONFERENCE RECORD OF THE 2000 IEEE INTERNATIONAL SYMPOSIUM ON ELECTRICAL INSULATION. (ISEI 2000). ANAHEIM, CA, APRIL 2-5, 2000; [INTERNATIONAL SYMPOSIUM ON ELECTRICAL INSULATION], NEW YORK, NY : IEEE, US, 2 avril 2000 (2000-04-02), pages 304-307, XP000977236, ISBN: 978-0-7803-5932-1

## Description

La présente invention concerne une méthode de mesure ultra-haute-fréquence (abrégé « UHF ») de décharge partielle, la dite mesure étant effectuée par un capteur ultra-haute-fréquence à au moins un point d'un poste électrique sous enveloppe métallique selon le préambule de la revendication 1. Egalement l'invention concerne un socle de maintien du capteur ultra-haute-fréquence mis en oeuvre dans le cadre de la méthode de mesure selon la revendication 1.

Les postes électriques sous enveloppe métallique (ou Gas Insulated Substation en anglais, communément désigné par la terminologie GIS) comprennent des éléments de coupures électriques adaptés à disjoncter ou alimenter des réseaux électriques à haute tension. Ces éléments de coupure électrique peuvent présenter une décharge partielle (abrégée « DP ») qui, plus précisément est une décharge partielle électrique localisée qui court-circuite partiellement un intervalle isolant séparant des conducteurs sous l'effet d'une forte tension. Il est important de pouvoir mesurer ces effets de décharge partielle, particulièrement sur site où se trouvent des postes électriques de type GIS. Une méthode adaptée à une telle mesure est connue sous le nom de mesure ultra-haute-fréquence (UHF), la dite mesure étant effectuée localement par un capteur ultra-haute-fréquence à au moins un point d'un poste électrique sous enveloppe métallique. Généralement, la mesure UHF utilise des fréquences sur des plages entre 100 MHz et 2 GHz, ce qui la rend robuste contre des sources de perturbations situées sur des fréquences plus basses ou sur des bandes étroites, comme la radio, et ainsi lui confère un bon rapport signal/bruit. La méthode de mesure trouve ainsi tout son intérêt pour le test de postes sous enveloppe métallique dans lesquels l'isolation est réalisée au moyen d'hexafluorure de soufre SF6. En effet, les décharges partielles dans ce gaz sont extrêmement brèves, la fréquence de mesure doit être très élevée. De plus, même si les postes électriques à enveloppe métallique sont testés élément par élément en usine, leur test final, notamment pour chercher des traces de poussières dans leurs compartiments ou autres raccords, ne peut être fait que monté et donc sur site (hors d'une cage de Faraday par exemple qui atténuerait des sources de perturbation). Le bon rapport signal/bruit est donc un autre avantage déterminant.

Comme capteur ultra-haute-fréquence, un ou des capteurs capacitifs à large bande passante sont utilisés en les disposant le plus souvent dans des compartiments du poste électrique. Pour ce type d'application des capteurs inductifs (aussi appelés "transformateur de courant haute fréquence"), qui mesurent le champ magnétique, ou capacitifs qui mesurent le champ électrique, peuvent être employés. Un possible défaut provient de la déformation et de l'atténuation du signal UHF émis et mesuré, en raison de réflexions parasites dudit signal dans les postes électriques, en particulier lorsque le capteur UHF est interne audit poste.

Une fois un poste électrique sous enveloppe métallique installé, il est souhaitable d'avoir installé un grand nombre de capteurs UHF de façon délocalisée dans le poste afin de pouvoir le contrôler et le maintenir sans devoir en réinstaller de nouveaux. Il est aussi nécessaire de pouvoir contrôler le bon fonctionnement des capteurs et si ceux-ci sont disposés dans le poste, il est nécessaire de pouvoir le retirer et le remplacer sans re-polluer le poste électrique. Ceci est une opération fort délicate.

Judd, M.D., "Dielectric Windows Improve Sensitivity of Partial Discharge Detection at UHF", IEEE Intl. Symp. on Electrical Insulation, Anaheim, CA, USA, Avril 2-5, 2000, pages 304-307, WO 2004/083878 A1, US 2010/084187 A1 divulguent la détection de décharges partielles en utilisant des capteurs UHF.

Un but de la présente invention est de proposer une méthode de mesure ultra-haute-fréquence (UHF) de décharge partielle, la dite mesure étant effectuée par un capteur ultra-haute-fréquence à au moins un point d'un poste électrique sous enveloppe métallique (GIS), ladite méthode permettant une mesure sur site plus simple pour un opérateur de contrôle et de maintenance.

A ces fins, un socle de maintien d'un capteur UHF est proposé au travers de la revendication 1.

Ainsi, l'invention permet au capteur d'être amovible et fixable externement à n'importe quel des nombreux hublots d'un poste électrique GIS. Il est donc facile de le disposer, de le déplacer, de le rajouter ultérieurement, de le retirer, de le réparer ou maintenir sans crainte de polluer le poste GIS. Un opérateur de contrôle et de maintenance peut ainsi effectuer des mesures, des maintenances et des réparations de façon très aisée et sans redouter des opérations complexes liés à des pollutions du poste GIS.

Afin de mettre en oeuvre l'invention, un socle de maintien avantageux est aussi proposé de façon à pouvoir mettre en contact très simplement le capteur UHF sur le hublot tout en assurant une mesure optimale en termes de rapport signal/bruit.

Un ensemble de sous-revendications présente également des avantages de l'invention.

Des exemples de mise en oeuvre et de réalisation des solutions proposées par l'invention sont fournis à l'aide de figures décrites :
- Figure 1: Vue d'ensemble d'un compartiment de poste GIS avec un socle de maintien de capteur UHF,
- Figure 2: Coupe transversale du socle de maintien et du capteur UHF,
- Figure 3: Forme de socle pour protection de perturbations électromagnétiques,
- Figure 4: Point de contact électrique du socle avec la masse,
- Figure 5: Module à ressort de positionnement et de maintien du socle,
- Figure 6: Disposition d'antenne de capteur UHF par rapport au socle de maintien.

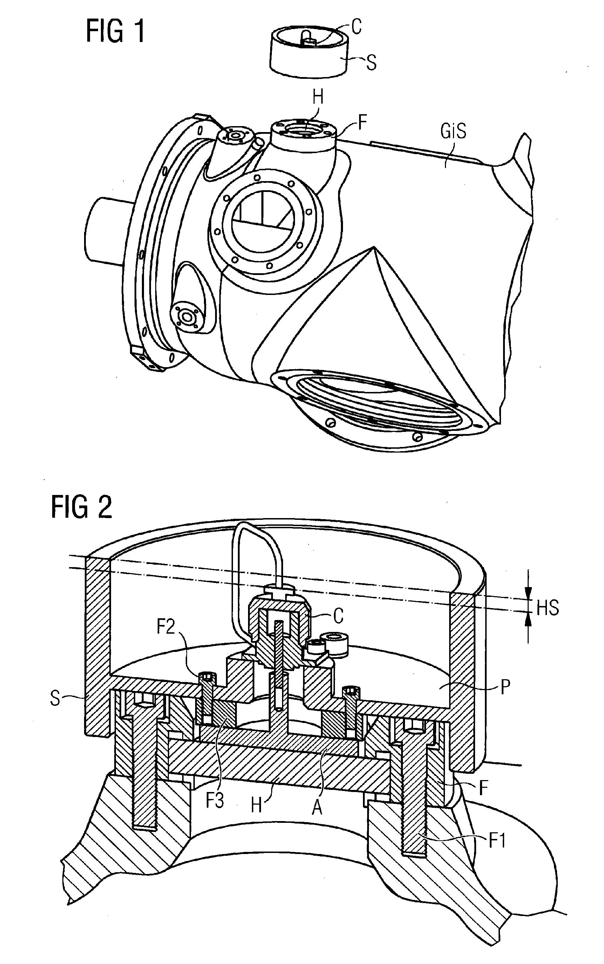

Figure 1 présente une vue d'ensemble d'un compartiment d'enveloppe d'un poste électrique sous enveloppe métallique GIS avec un socle de maintien S de capteur ultra-haute-fréquence C avant sa mise en contact avec un hublot H prévu sur la paroi du poste GIS. Le hublot H en verre sécurisé et de forme ici circulaire est solidarisé à l'enveloppe du poste GIS au moyen d'un anneau de fixation F, généralement vissé dans des filetages de l'enveloppe du poste GIS.

Figure 2 présente une coupe diamétralement transversale du socle de maintien S et du capteur C selon figure 1, après mise en contact du capteur C avec la surface externe du hublot H. Le socle de maintien de forme tubulaire pour venir se glisser autour de l'anneau de fixation F comprend principalement deux alvéoles tubulaires séparé par un plateau P. La première alvéole inférieure au plateau vient recouvrir l'anneau de fixation F et la partie externe de hublot. Le capteur C (au sens de sa partie connecteur) est solidarisé au plateau P par des boulons F2 dans la deuxième alvéole supérieure audit plateau P. Le plateau P comprend une ouverture centrale sur laquelle une tête-connecteur du capteur C est fixée et au travers de laquelle le capteur C présente un guide d'onde jusqu'à son antenne A en contact avec la surface externe du hublot H (l'antenne A étant le récepteur des ondes UHF à mesurer dans le poste GIS). L'appui pour le contact de l'antenne A sur le hublot est optimalement garanti si un anneau intermédiaire de pression F3 est disposé dans la première alvéole inférieure entre le plateau P et l'antenne A. L'anneau de pression F3 est vissé au plateau P par des boulons à tête vissables depuis la deuxième alvéole supérieure du socle S. Le hublot H est solidarisé à l'enveloppe du poste GIS au moyen de l'anneau de fixation F, maintenu vissé dans des filetages de l'enveloppe du poste GIS par des boulons F1.

Selon cette configuration, il est ainsi possible de réaliser le socle S de maintien d'un capteur ultra-haute-fréquence C mis en oeuvre dans le cadre de la méthode de mesure, le dit socle S présentant des moyens de fixation F, F1 sur un hublot H permettant une mise en contact du capteur C, A sur le hublot H, lesdits moyens de fixation F, F1 étant amovibles du hublot H.

Principalement, le capteur C délivre un signal de mesure depuis l'alvéole supérieure vers une unité de contrôle de mesure. Cette liaison entre capteur et unité peut être filaire voire aérienne au moyen par exemple d'un couplage. Ceci peut se faire au moyen d'un émetteur couplé à une sortie d'au moins un capteur de mesure, ledit émetteur permettant une liaison de signal avec un récepteur reliée à une entrée de l'unité de contrôle de mesure. Cela permet ainsi de réaliser des mesures à distances sans branchement et via un protocole de communication standard simple (par exemple WiFi). Il est possible de disposer une RFID (Radio Frequency Identificator) sur chaque socle S ou son capteur C pour contrôler et identifier des parcs de capteurs en utilisant un lecteur de RFID. Cela simplifie le contrôle de l'opérateur qui interroge un RFID et les autres RFID du parc de capteur dans un GIS via des processus d'intercommunication « hop-by-hop » entre les RFIDs.

Concernant la figure 2, il est à noter que le socle S présente une paroi latérale d'une hauteur supérieure ou égale à celle du capteur (partie connecteur et partie antenne) et, le cas échéant, aussi à la hauteur d'un moyen de connexion annexe couplé au capteur. Cette différence de hauteur HS permet de protéger considérablement la connexion du capteur vers l'unité de contrôle de mesure, aussi bien en termes de protection mécanique qu'électromagnétique. Egalement, un opérateur peut aisément prendre en main la paroi du socle sans venir toucher/abimer le capteur.

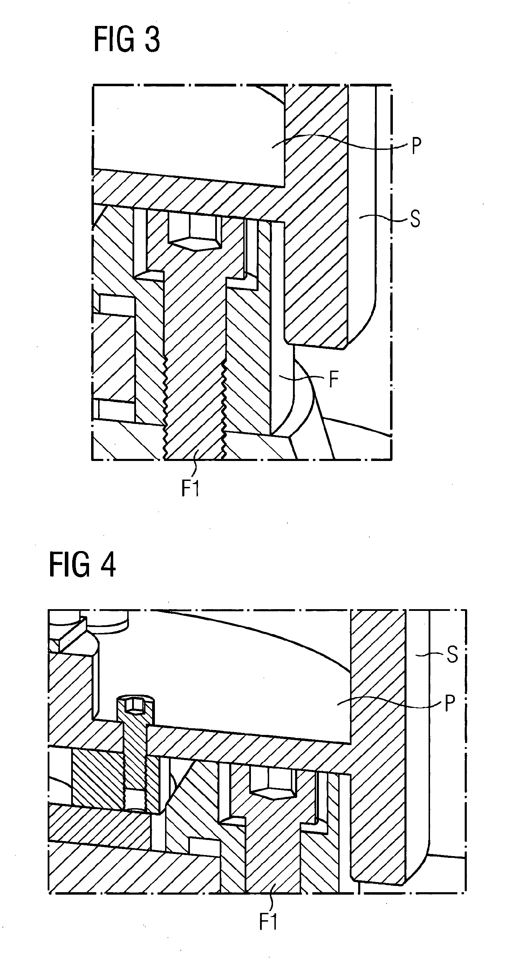

Figure 3 présente une forme de socle S pour protection de perturbations électromagnétiques. Le socle S, en raison de sa forme avantageusement choisie en H sous une coupe diamétrale, présente une paroi latérale recouvrant au moins partiellement la circonférence latérale de l'ensemble hublot H et son moyen/anneau de fixation F. Cette paroi de l'alvéole inférieure est suffisamment haute et épaisse pour obtenir un blindage électromagnétique suffisant contre des perturbations externes pouvant gêner la mesure de l'antenne A sur le hublot. De même, la hauteur et l'épaisseur de la paroi latérale de l'alvéole supérieure sont suffisantes pour protéger la tête de capteur C contre ces effets parasites.

Figure 4 présente un aspect de point de contact électrique du socle S avec la masse. Le plateau P d'appui, sur lequel est fixé le capteur, est électriquement mis en contact avec la terre au moyen d'au moins un raccord électriquement conducteur avec le poste électrique sous enveloppe métallique GIS, tel qu'un élément métallique de fixation (boulons F1 avec une tête en contact avec la surface inférieure de plateau P) du hublot sur ledit poste. Ainsi, le socle, une masse du capteur peuvent aussi être entièrement couplés à la même masse que le poste GIS. La forme du socle de maintien et son plateau est aussi particulièrement adaptée pour assurer un contact de l'antenne parfait avec la surface externe de hublot.

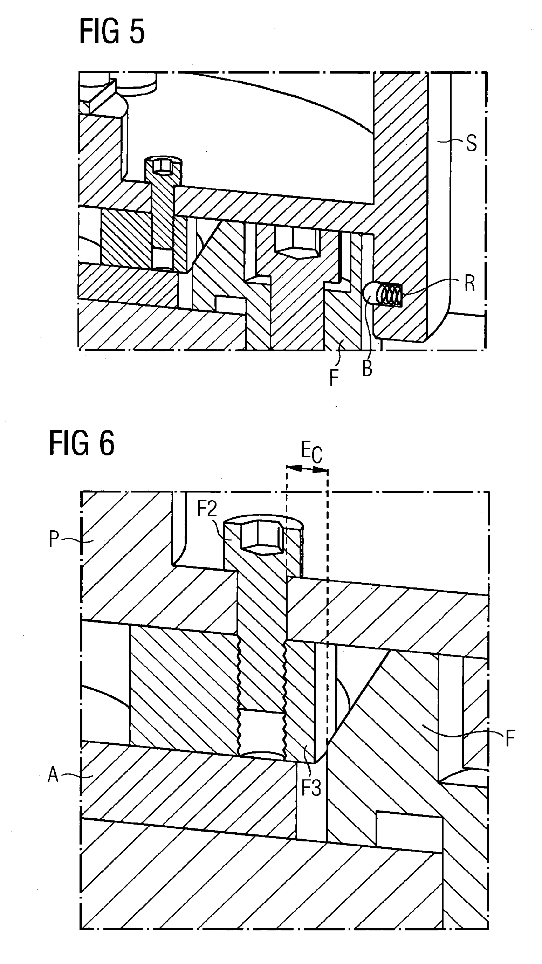

Figure 5 présente un module à ressort de positionnement et de maintien du socle S. Le socle S comprend au moins un module B, R à ressort R de positionnement et de maintien étant disposé sur une paroi latérale intérieure du socle S afin de venir appuyer sur une partie circonférentielle (anneau de fixation F) couplée au hublot H. Un bouton poussoir manuel peut aussi être ajouté pour facilité l'enfilage du socle S sur l'anneau de fixation F. Egalement, la partie circonférentielle F peu comprendre une encoche dans laquelle le module à ressort peut s'arrimer et se laisser désolidariser manuellement.

Figure 6 présente une disposition d'antenne A de capteur UHF par rapport au socle de maintien S. L'antenne A est choisie plane et disposée en partie/alvéole inférieure de socle S. Enfin, elle est apte à être mis en appui contre la surface externe de hublot en ménageant un vide autour de l'antenne, ledit vide formant un écart latéral (Ec) entre l'antenne A et le moyen de fixation F du hublot. Cet écart est en effet requis afin d'éviter une mise à la masse de l'antenne du capteur C et donc pour éviter un court-circuit intempestif.

## Revendications

1. Socle de maintien d'un capteur ultra-haute-fréquence mis en oeuvre dans le cadre d'une méthode de mesure ultra-haute-fréquence (UHF) de décharge partielle (DP), la dite mesure étant effectuée par ledit capteur ultra-haute-fréquence (C) à au moins un point d'un poste électrique sous enveloppe métallique (GIS), le dit socle (S) présentant des moyens de fixation (F1, F) sur un hublot (H) permettant une mise en contact du capteur (C) sur le hublot, lesdits moyens de fixation étant amovibles du hublot, **caractérisé en ce que** le socle présente une paroi latérale d'une hauteur supérieure ou égale à celle du capteur.,

2. Socle selon revendication 1, comprenant un émetteur couplé à une sortie d'au moins un capteur de mesure, ledit émetteur permettant une liaison de signal un récepteur relié à une entrée d'une unité de contrôle de mesure. Ladite liaison étant filaire ou de type radio.

3. Socle selon une des revendications 1 à 2 présentant une paroi latérale d'une hauteur supérieure ou égale à la hauteur d'un moyen de connexion couplé au capteur.

4. Socle selon une des revendications 1 à 3 présentant une paroi latérale recouvrant au moins partiellement la circonférence latérale de l'ensemble hublot.

5. Socle selon une des revendications 1 à 4 comprenant un plateau d'appui sur lequel est fixé le capteur, le dit plateau étant électriquement mis en contact avec la terre au moyen d'au moins un raccord électriquement conducteur avec le poste électrique sous enveloppe métallique, tel qu'un élément métallique de fixation de hublot sur ledit poste.

6. Socle selon une des revendications 1 à 4 comprenant au moins un module à ressort de positionnement et de maintien étant disposé sur une paroi latérale intérieure du socle afin de venir appuyer sur une partie circonférentielle au hublot.

7. Socle selon revendication 6 pour lequel la partie circonférentielle comprend une encoche dans laquelle le module à ressort peut s'arrimer et se laisser désolidariser manuellement.

8. Socle selon revendication 6 pour lequel le capteur comprend une antenne plane disposée en partie inférieure de socle et apte à être mis en appui contre la surface externe de hublot en ménageant un vide autour de l'antenne, ledit vide formant un écart latéral entre l'antenne A et le moyen de fixation F du hublot.

9. Socle selon une des revendications 1 à 8 comprenant un RFID disposé sur ledit socle ou le capteur C.

## Patentansprüche

1. Sockel für einen Ultrahochfrequenzsensor, der im Rahmen eines Verfahrens zur Ultrahochfrequenzmessung (UHF) der Teilentladung (TE) eingesetzt wird, wobei diese Messung von diesem Ultrahochfrequenzsensor (C) an mindestens einem Punkt einer metallgekapselten Schaltanlage (GIS) durchgeführt wird, wobei der Sockel (S) Befestigungsmittel (F1, F) zur Befestigung an einem Schauglas (H) aufweist, die ein Inkontaktbringen des Sensors (C) auf dem Schauglas ermöglichen, wobei die Befestigungsmittel vom Schauglas abnehmbar sind, **dadurch gekennzeichnet, dass** der Sockel eine Seitenwand aufweist, die höher als der Sensor oder gleich hoch ist.

2. Sockel nach Anspruch 1 mit einem Sender, der an einen Ausgang mindestens eines Messsensors gekoppelt ist, wobei dieser Sender eine Signalverbindung mit einem Empfänger ermöglicht, der mit einem Eingang einer Messsteuereinheit verbunden ist. Diese Verbindung ist drahtgebunden oder eine Funkverbindung.

3. Sockel nach einem der Ansprüche 1 bis 2, der eine Seitenwand aufweist, die höher als ein an den Sensor gekoppeltes Verbindungsmittel oder gleich hoch ist.

4. Sockel nach einem der Ansprüche 1 bis 3, der eine Seitenwand aufweist, die den seitlichen Umfang der Schauglasanordnung mindestens teilweise überdeckt.

5. Sockel nach einem der Ansprüche 1 bis 4 mit einer Auflageplatte, auf welcher der Sensor befestigt ist, wobei die Platte elektrisch mit der Erde über mindestens eine elektrisch leitende Verbindung zur metallgekapselten Schaltanlage wie beispielsweise über ein metallenes Befestigungselement des Schauglases an der Schaltanlage verbunden ist.

6. Sockel nach einem der Ansprüche 1 bis 4 mit mindestens einem Modul mit Positionier- und Haltefeder, das an einer seitlichen Innenwand des Sockels angeordnet ist, um sich an einem Umfangsteil am Schauglas abzustützen.

7. Sockel nach Anspruch 6, bei dem der Umfangsteil eine Nut umfasst, in die das Federmodul einrasten kann und aus der es manuell gelöst werden kann.

8. Sockel nach Anspruch 6, bei dem der Sensor eine flache Antenne umfasst, die im unteren Teil des Sockels angeordnet ist und geeignet ist, an die Außenoberfläche des Schauglases angelegt zu werden, wobei ein Hohlraum um die Antenne gebildet wird, der einen seitlichen Abstand zwischen der Antenne A und dem Befestigungsmittel F des Schauglases bildet.

9. Sockel nach einem der Ansprüche 1 bis 8 mit einem RFID, der an diesem Sockel oder am Sensor C angeordnet ist.

## Claims

1. Support for holding an ultra-high frequency sensor used as part of a method for measuring ultra-high frequency (UHF) partial discharge (PD), said measurement being made by said ultra-high frequency sensor (C) at at least one point on an electricity substation beneath a metal housing (GIS), said support (S) having means for fixing (F1, F) on a window (H) providing for contact between the sensor (C) and the window, said fixing means being detachable from the window, **characterised in that** the support has a side wall of a height greater than or equal to that of the sensor.

2. Support according to claim 1, including an emitter coupled to an output from at least one measuring sensor, said emitter providing for a signal link with a receiver connected to an input to a measurement control unit. Said link being by wire or radio.

3. Support according to one of claims 1 to 2 having a side wall of a height greater than or equal to the height of a connection means coupled to the sensor.

4. Support according to one of claims 1 to 3 having a side wall covering at least partially the lateral circumference of the window assembly.

5. Support according to one of claims 1 to 4 including a supporting plate to which the sensor is fixed, said plate being brought into electrical contact with ground by means of at least one electrically conducting connection with the electricity substation beneath a metal housing, such as a metal element for fixing the window to said substation.

6. Support according to one of claims 1 to 4 including at least one spring positioning and holding module being placed on an inner side wall of the support in order to rest on a circumferential part on the window.

7. Support according to claim 6 wherein the circumferential part includes a notch in which the spring module can be secured and detached manually.

8. Support according to claim 6 wherein the sensor includes a flat antenna placed on the lower part of the support and capable of resting against the outer surface of the window arranging a void around the antenna, said void forming a lateral gap between the antenna A and the means for fixing F the window.

9. Support according to one of claims 1 to 8 including an RFID arranged on said support or the sensor C.
